# EUROPÄISCHE PATENTSCHRIFT

(11) **EP 2 614 576 B1**
(45) Veröffentlichungstag und Bekanntmachung des Hinweises auf die Patenterteilung: **10.10.2018**
(21) Anmeldenummer: 11757158.8
(22) Anmeldetag: 16.08.2011
(51) Int. Cl.: H02J 7/35, H01L 31/02

(54) **LOKALES ENERGIEVERTEILUNGSSYSTEM MIT EINEM ZWISCHENKREIS**
LOCAL ENERGY DISTRIBUTION SYSTEM HAVING AN INTERMEDIATE CIRCUIT
SYSTÈME LOCAL DE DISTRIBUTION D'ÉNERGIE COMPORTANT UN CIRCUIT INTERMÉDIAIRE

(30) Priorität: 10.09.2010 DE 102010044976
(43) Veröffentlichungstag der Anmeldung: 17.07.2013
(73) Patentinhaber: Sew-Eurodrive GmbH & Co. KG, 76646 Bruchsal (DE)
(72) Erfinder: SCHMIDT, Josef, 76676 Graben-Neudorf (DE)
(74) Vertreter: Tüngler, Eberhard
(86) Internationale Anmeldenummer: PCT/EP2011/004095
(87) Internationale Veröffentlichungsnummer: WO 2012/031662

(56) Entgegenhaltungen:
- EP-A2- 2 071 693
- WO-A2-03/098703
- US-A1- 2010 139 734

## Beschreibung

Die Erfindung betrifft ein System, insbesondere ein lokales Energieverteilungssystem, mit einem Zwischenkreis, ein Verfahren zur Regelung des Energieflusses in einem System und eine Verwendung von in verschiedenen Gehäusen angeordneten Stellern eines Systems.

Aus der WO 03/098703 A2 ist bekannt, die von Solarzellen erzeugte Leistung über einen AC-DC-Steller einem öffentlichen Wechelstromversorgungsnetz zuzuführen.

Der Erfindung liegt daher die Aufgabe zugrunde, ein lokales dezentrales System weiterzubilden.

Erfindungsgemäß wird die Aufgabe bei dem System mit einem Zwischenkreis nach Anspruch 1 angegebenen Merkmalen gelöst.

Wichtige Merkmale der Erfindung bei dem System sind, dass das System mit einem Zwischenkreis, insbesondere unipolarem Zwischenkreis, insbesondere Gleichspannungszwischenkreis, ausgeführt ist,
wobei ein Wechselstromnetz über einen AC-DC-Steller mit dem Zwischenkreis verbunden ist,
wobei über zumindest einen weiteren Steller, insbesondere DC-DC-Steller, zumindest einem Verbraucher und/oder Energiespeicher aus dem Zwischenkreis zuführbar ist,
wobei eine übergeordnete Regeleinheit mit zumindest zwei Stellern mittels einer Datenübertragungsleitung verbunden ist, insbesondere zur Sollwertvorgabe.

Von Vorteil ist dabei, dass die von der Energieerzeugungsquelle, beispielsweise Solarzellen, erzeugte Energie hauptsächlich lokal verbraucht wird und nur der Überschuss an Energie dem öffentlichen Versorgungsnetz zuzuführen. Lokal bezieht sich hierbei auf eine Entfernung von beispielsweise weniger als 1 km, insbesondere weniger als 100 Meter. Vorzugsweise sind die Solarzellen auf dem Dach eines Gebäudes angeordnet und die Verbraucher innerhalb des Gebäudes oder im direkten Nahfeld zum Gebäude. Der Verbraucher ist hierbei als Waschmaschine oder als Elektroauto ausführbar, wobei das Elektroauto einen Energiespeicher umfasst und somit auch zur Abpufferung von Energieschwankungen verwendbar ist. Insbesondere ist also die von der Energieerzeugungsquelle erzeugte Energie dem Energiespeicher im Elektroauto zuführbar. Nach vollständigem Aufladen des Energiespeichers ist keine Leistung mehr von diesem aufnehmbar. Somit ist dann die erzeugte elektrische Leistung von weiteren am Zwischenkreis angeschlossenen Verbrauchern oder Energiespeichern aufnehmbar. Die übergeordnete Regeleinheit steuert die den jeweiligen Verbrauchern und Energiespeichern zugeordneten Steller derart an, dass stets eine maximale Leistung der Energieerzeugungsquelle entnehmbar ist. Falls die Verbraucher und Energiespeicher die erzeugte elektrische Leistung nicht vollständig aufnehmen können, wird der AC-DC-Steller von der übergeordneten Regeleinheit derart angesteuert, dass die überschüssige Leistung ans Wechselstromnetz abgeführt wird. Insgesamt ist aber durch den lokalen Verbrauch der erzeugten Energie eine geringere maximale Leistung ans Wechselstromnetz abzuführen als bei vollständiger Abfuhr der von der Energieerzeugungsquelle erzeugten elektrischen Leistung ans Wechselstromnetz. Entsprechend sind die Leitungen zum Wechselstromnetz mit einem dünneren Querschnitt ausgeführt als bei vollständiger Abfuhr der erzeugten Leistung ans Wechselstromnetz. Hierdurch sind viel kostengünstigere elektrische Verbindungsleitungen einsetzbar.

Bei einer vorteilhaften Ausgestaltung sind die Steller in verschiedenen Gehäusen angeordnet. Von Vorteil ist dabei, dass die übergeordnete Regeleinheit die Steller als Stellglieder benutzt. Dabei ist besonders vorteilhaft, dass mehrere Steller benutzbar sind von der Regeleinheit. Entsprechend einer Priorisierung und der von den Stellern beziehungsweise von den den Stellern jeweils zugeordneten Geräten wird die Energie abgeführt an die Geräte, also den jeweiligen Stellern zugeordneten Verbraucher oder Energiespeicher.

Bei einer vorteilhaften Ausgestaltung weist ein oder jeder Steller zumindest einen steuerbaren Leistungshalbleiterschalter, insbesondere IGBT, MOSFET, Thyristor oder dergleichen, auf,
insbesondere wobei der Leistungshalbleiterschalter in einer Halbbrückenanordnung von gleichartigen Leistungshalbleitern angeordnet ist. Von Vorteil ist dabei, dass der Steller als Hochsetzsteller, Tiefsetzsteller oder als einphasige oder mehrphasige Halbbrückenschaltung ausführbar ist.

Bei einer vorteilhaften Ausgestaltung sind als Datenübertragungsleitung die Stromschienen des Zwischenkreises verwendet, insbesondere indem zur Datenübertragung höher frequente Stromanteile aufmoduliert sind. Von Vorteil ist dabei, dass keine zusätzlichen Leitungen zur Datenübertragung notwendig sind.

Bei einer vorteilhaften Ausgestaltung steuert einer der weiteren Steller die Energiezufuhr vom Zwischenkreis an einen zum Steller zugehörigen Verbraucher, insbesondere wobei der weitere Steller im Gehäuse des Verbrauchers angeordnet ist oder in einem eigenen Gehäuse. Von Vorteil ist dabei, dass die Verbraucher regelbar sind mittels ihrer jeweils zugeordneten Steller. Dies bedeutet, dass die Leistungszufuhr an den Verbraucher, also die Leistungsentnahme aus dem Zwischenkreis, von der übergeordneten Regeleinheit beeinflussbar ist. Bei Ausführung des Verbrauchers als Energiespeicher ist auch die Leistungsübertragung vom Energiespeicher an den Zwischenkreis regelbar.

Bei einer vorteilhaften Ausgestaltung steuert einer der weiteren Steller den Energieaustausch zwischen Zwischenkreis und einem zum weiteren Steller zugehörigen Energiespeicher, insbesondere wobei der weitere Steller im Gehäuse des Energiespeichers angeordnet ist oder in einem eigenen Gehäuse. Von Vorteil ist dabei, dass die übergeordnete Regeleinheit mehrere Steller als Stellglieder verwendet und somit gemäß Priorisierung den Leistungsfluss steuert. Hierbei ist solange Leistung an den Energiespeicher zuführbar, solange dieser nicht vollständig aufgeladen ist. Wichtig ist dabei auch, dass der Steller nicht im Gehäuse der übergeordneten Regeleinheit angeordnet ist sondern separat, also in einem eigenen Gehäuse oder im Gehäuse des Energiespeichers. Zwischen übergeordneter Regeleinheit und Steller ist also eine Kommunikationsschnittstelle vorgesehen, so dass verschiedenartige Steller am Zwischenkreis anschließbar sind und für das System verwendbar sind, solange diese kompatibel zur Kommunikationsschnittstelle Daten austauschen können. Beispielhaft überträgt die übergeordnete Regeleinheit Sollwerte an die Steller, so dass in den Stellern vorgesehene Regler erfasst Istwerte auf diese Sollwerte hin regeln.

Bei einer vorteilhaften Ausgestaltung weist der Zwischenkreis Stromschienen auf. Von Vorteil ist dabei, dass hohe Ströme durchleitbar sind innerhalb des Zwischenkreises. Insbesondere sind diese Ströme geringer, insbesondere betragen sie nur ein Drittel, als die ans Wechselstromnetz zugeführten Ströme.

Wichtige Merkmale bei dem System, insbesondere lokales Energieverteilungssystem, sind, dass es mit einem Gleichspannungszwischenkreis als gemeinsamer Verbindungsschiene oder Verbindungsknoten ausgestattet ist,
wobei der Zwischenkreis über einen AC-DC-Steller mit einem öffentlichen Wechselstrom-Versorgungsnetz verbunden ist und mit mindestens einer lokalen Energieerzeugungsquelle verbunden ist,
wobei an den Zwischenkreis zumindest regelbarer Verbraucher, insbesondere wobei der Leistungsfluss zwischen Zwischenkreis und Verbraucher regelbar ist, angeschlossen ist,
wobei eine MPP-Regeleinheit für die Energieerzeugungsquelle beziehungsweise Energieerzeugungsquellen vorgesehen ist, die in Abhängigkeit vom Energiebedarf der angeschlossenen Verbraucher verschiedene Steller des Systems zur MPP-Regelung verwendet,
insbesondere wobei der oder die Verbraucher von der übergeordneten MPP-Regeleinheit regelbar sind.

Von Vorteil ist dabei, dass eine MPP-Regelung anwendbar ist, die allerdings mehrere Stellglieder benutzt, nämlich die regelbaren Verbraucher. Die Sollwertvorgabe erfolgt dabei gemäß Priorisierung der Verbraucher oder gemäß einer in der übergeordneten Regeleinheit hinterlegten Regel.

Bei einer vorteilhaften Ausgestaltung ist zumindest einer der Verbraucher ein Energiespeicher. Von Vorteil ist dabei, dass Energie abspeicherbar ist und somit Leistungsschwankungen abpufferbar. Außerdem ist als Energiespeicher ein Energiespeicher eines Elektroautos verwendbar.

Bei einer vorteilhaften Ausgestaltung ist der Energiespeicher als elektrischer oder chemischer Energiespeicher ausgeführt, insbesondere Akkumulator, Ultracap, Batterie oder als sonstiger mechanischer Energiespeicher, wie Schwungrad oder dergleichen, ausgeführt ist. Von Vorteil ist dabei, dass verschiedene Energiespeicher verwendbar sind, solange die aus dem Zwischenkreis zugeführte Leistung steuerbar ist, insbesondere mittels eines jeweiligen Stellers.

Wichtige Merkmale bei einem Verfahren zur Regelung des Energieflusses in einem System, insbesondere lokales Energieverteilungssystem, sind, dass das System
mit einem Gleichspannungszwischenkreis als gemeinsamer Verbindungsschiene oder Verbindungsknoten ausgeführt ist,
wobei der Zwischenkreis über einen AC-DC-Steller mit einem öffentlichen Wechselstrom-Versorgungsnetz verbunden ist und mit mindestens einer lokalen Energieerzeugungsquelle verbunden ist,
wobei an den Zwischenkreis zumindest regelbarer Verbraucher angeschlossen ist,
wobei ein MPP-Regelverfahren für die Energieerzeugungsquelle beziehungsweise Energieerzeugungsquellen verwendet wird, bei dem in Abhängigkeit vom Energiebedarf der angeschlossenen Verbraucher verschiedene Steller des Systems zur MPP-Regelung verwendet werden.

Von Vorteil ist dabei, dass mehrere Stellglieder verwendet werden, die entsprechend einer in der übergeordneten Regeleinheit hinterlegten Priorisierung oder Regel entsprechende Sollwertvorgaben erhalten.

Wichtige Merkmale bei einer Verwendung von in verschiedenen Gehäusen angeordneten Stellern eines Systems insbesondere eines lokalen Energieverteilungssystems bei einem MPP-Regelverfahren sind, dass das Verfahren zur Regelung des Energieflusses in einem System mit einem Gleichspannungszwischenkreis als gemeinsamer Verbindungsschiene oder Verbindungsknoten vorgesehen ist,
wobei der Zwischenkreis über einen AC-DC-Steller mit einem öffentlichen Wechselstrom-Versorgungsnetz verbunden ist und mit mindestens einer lokalen Energieerzeugungsquelle verbunden ist,
wobei an den Zwischenkreis zumindest regelbarer Verbraucher angeschlossen ist,
wobei ein MPP-Regelverfahren für die Energieerzeugungsquelle beziehungsweise Energieerzeugungsquellen verwendet wird, bei dem in Abhängigkeit vom Energiebedarf der angeschlossenen Verbraucher verschiedene Steller des Systems zur MPP-Regelung verwendet werden.
Von Vorteil ist dabei, dass mehrere separat angeordnete Stellglieder verwendet werden, also nicht nur ein einziges.

Weitere Vorteile ergeben sich aus den Unteransprüchen.

Die Erfindung wird nun anhand von Abbildungen näher erläutert:

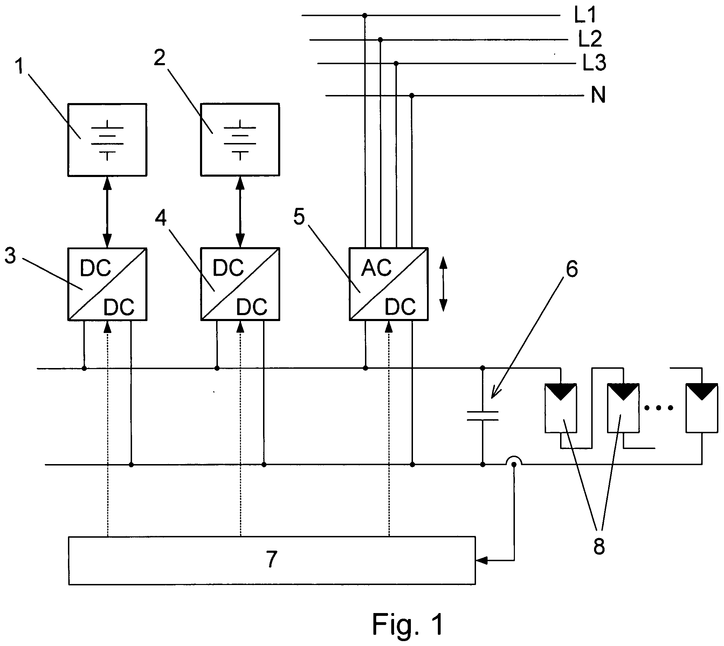

In der Figur 1 ist ein erstes erfindungsgemäßes Ausführungsbeispiel schematisch dargestellt.

Dabei ist ein Zwischenkreis vorgesehen, an dem mehrere Geräte angeschlossen sind. Im Zwischenkreis wird die dort vorhandene unipolare Spannung mittels des Zwischenkreiskondensators 6 geglättet.
Aus einem ersten Energiespeicher ist Energie an den Zwischenkreis zuführbar oder diesem entnehmbar. Vorzugsweise erfolgt dies über einen DC-DC-Wandler 3. Somit darf die Spannung am Energiespeicher 1 unterschiedlich sein von der Zwischenkreisspannung. Der DC-DC-Wandler 3 umfasst zumindest einen steuerbaren Leistungshalbleiterschalter, so dass der Leistungsfluss zwischen Energiespeicher 1 und Zwischenkreis steuerbar ist. Außerdem umfasst er einen Regler, welcher mit einem Mittel zur Erfassung der Zwischenkreisspannung und mit einem Mittel zur Erfassung der Spannung am Energiespeicher verbunden ist. Auf diese Weise ist der Leistungsfluss gemäß einer Sollwertvorgabe steuerbar. Statt eines oder der Mittel zur Erfassung der beiden Spannungen und/oder zusätzlich zu diesen ist auch ein Mittel zur Erfassung des vom Energiespeicher zum Zwischenkreis fließenden Stroms mit dem Regler verbindbar.
Eine Sollwertvorgabe wird von einer übergeordneten Regeleinheit 7 an den Regler übermittelt.
Der Energiespeicher ist als elektrischer oder chemischer Energiespeicher, wie beispielsweise Akkumulator, Ultracap beziehungsweise Batterie, oder als sonstiger mechanischer Energiespeicher, wie Schwungrad oder dergleichen, ausführbar.

Ebenso ist zumindest ein weiterer Energiespeicher 2 an den Zwischenkreis anschließbar, der beispielhaft in einem Elektroauto vorgesehen ist. Beispielhaft ist dieser Energiespeicher als Hochvoltbatterie ausgeführt oder als sonstiger Akkumulator. Wie auch beim ersten Energiespeicher 1 ist wiederum ein entsprechend ausgeführter DC-DC-Wandler 4 vorgesehen. Auch dessen Regler ist eine Sollwertvorgabe von der übergeordneten Regeleinheit 7 zuführbar.

Als weiteres Gerät ist ein AC-DC-Wandler 5 an den Zwischenkreis angeschlossen, der wechselspannungsseitig, also AC-seitig, mit einem Wechselstromnetz verbunden ist, so dass diesem Energie entnommen oder zugeführt werden kann. Hierzu umfasst der AC-DC-Wandler 5 zumindest einen steuerbaren Leistungshalbleiterschalter, so dass der Leistungsfluss zwischen Wechselstromnetz (L1, L2, L3) und Zwischenkreis steuerbar ist. Außerdem umfasst er einen Regler, welcher mit einem Mittel zur Erfassung der Zwischenkreisspannung und mit einem Mittel zur Erfassung der Spannung am Wechselstromnetz (L1, L2, L3) verbunden ist. Auf diese Weise ist der Leistungsfluss gemäß einer Sollwertvorgabe steuerbar. Statt eines oder der Mittel zur Erfassung der beiden Spannungen und/oder zusätzlich zu diesen ist auch ein Mittel zur Erfassung des vom Wechselstromnetz (L1, L2, L3) zum Zwischenkreis fließenden Stroms mit dem Regler verbindbar.

Eine Sollwertvorgabe wird von einer übergeordneten Regeleinheit 7 an den Regler des AC-DC-Wandlers 5 übermittelt.

Die Energiequelle 8 ist vorzugsweise als Anordnung von Solarzellen ausgeführt. Abhängig von eingestrahltem Licht, insbesondere Sonnenlicht, wird somit elektrische Energie erzeugt und dem Zwischenkreis zugeführt. Im Zeitverlauf schwankt die Lichtintensität beispielsweise abhängig vom Bewölkungsverlauf erheblich.

Die übergeordnete Regeleinheit 7 umfasst einen MPP-Regler, also einen Maximum-Power-Point - Regler. Dieser Regler regelt die Leistungsflüsse derart, dass der Energiequelle der maximale Leistungsfluss entnommen wird. Hierzu werden die Sollwertvorgaben von der Regeleinheit 7 an die Geräte entsprechend bestimmt.

Dabei werden die Energiespeicher priorisiert und die von der Energiequelle 8 erzeugte Leistung zunächst demjenigen Gerät mit der höchsten Priorität zugeführt. Übersteigt die erzeugte Leistung einen kritischen Wert, wird Leistung an das Gerät mit der niedrigeren Priorität abgeführt. Falls die Energiespeicher entfernt sind oder in Summe nicht die maximal erzeugbare Leistung der Energiequelle 8 aufzunehmen vermögen, wird Leistung über den AC-DC-Regler 5 dem Wechselstromnetz (L1, L2, L3) zugeführt.

In einem weiteren erfindungsgemäßen Ausführungsbeispiel sind anstatt der Energiespeicher (3, 4) oder zusätzlich zu diesen Energieverbraucher mit dem Zwischenkreis verbunden und aus diesem versorgbar. Vorzugsweise sind auch diese beeinflussbar von der übergeordneten Regeleinheit. Dies ist besonders einfach ausführbar, wenn der den Verbrauchern zugeführte Energiefluss über steuerbare Leistungsschalter, insbesondere Leistungshalbleiterschalter, steuerbar ist und somit die Ansteuersignale von der übergeordneten Regeleinheit 7 beeinflussbar sind.

Die genannten Wandler sind steuerbar und somit auch als Steller bezeichenbar.

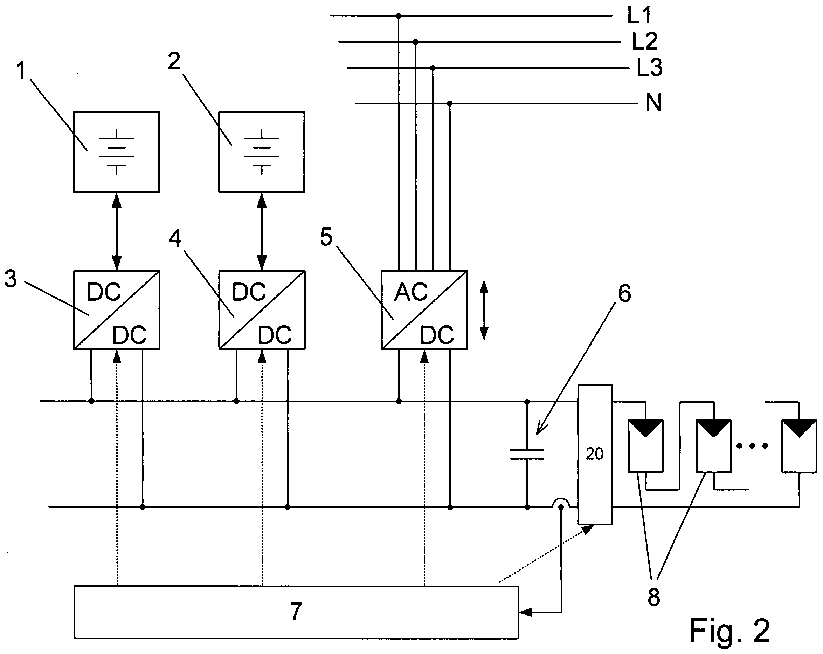

In dem Ausführungsbeispiel nach Figur 2 ist eine MPP- Regelung im Power-Tracker 20 angeordnet.

Die Regeleinheit 7 arbeitet hier als übergeordnete Regeleinheit, welche dem Power-Tracker 20 einen entsprechenden Sollwert vorgibt und die anderen Wandler derart ansteuert, dass eine optimale Energieausnutzung erreicht wird. Somit ist auch ermöglicht, dass die an der Energieerzeugungsquelle auftretende Spannung unterschiedlich von der Gleichspannungs-Zwischenkreisverschienung, an welche alle Wandler (3, 4, 5) mit ihrem DC- Anschluss elektrisch angeschlossen sind, ist.

### Bezugszeichenliste

1 Energiespeicher
2 Elektroauto
3 DC-DC-Wandler
4 DC-DC-Wandler
5 AC-DC-Wandler
6 Zwischenkreiskondensator
7 Regeleinheit
8 Energiequelle, insbesondere Solarzellen
20 Power-Tracker

## Patentansprüche

1. System mit einem Zwischenkreis, insbesondere unipolarem Zwischenkreis, insbesondere Gleichspannungszwischenkreis, umfassend einen AC-DC-Steller (5), der mit dem Zwischenkreis verbunden ist, **gekennzeichnet durch** zumindest einen weiteren Steller, der als DC-DC-Steller (3, 4) ausgeführt ist, über dem zumindest einem Verbraucher und/oder Energiespeicher (1, 2) Energie und/oder Strom aus dem Zwischen kreis zuführbar ist, eine übergeordnete Regeleinheit (7), die mit zumindest zwei Stellern (3, 4, 5) mittels einer Datenübertragungsleitung direkt verbunden ist, insbesondere zur Sollwertvorgabe, einen Powertracker (20), der zwischen eine Energieerzeugungsquelle (8) und dem Zwischenkreis geschaltet ist, und eine MPP-Regeleinheit, die den Powertracker (20) steuert und von der übergeordneten Regeleinheit (7) eine Sollwertvorgabe für eine MPP-Regelung erhält.

2. System nach Anspruch 1,
**dadurch gekennzeichnet, dass**
die Steller in verschiedenen Gehäusen angeordnet sind.

3. System nach mindestens einem der vorangegangenen Ansprüche,
**dadurch gekennzeichnet, dass**
ein oder jeder Steller zumindest einen steuerbaren Leistungshalbleiterschalter, insbesondere IGBT, MOSFET oder Thyristor, aufweist,
insbesondere wobei der Leistungshalbleiterschalter in einer Halbbrückenanordnung von gleichartigen Leistungshalbleitern angeordnet ist.

4. System nach mindestens einem der vorangegangenen Ansprüche,
**dadurch gekennzeichnet, dass**
als Datenübertragungsleitung die Stromschienen des Zwischenkreises verwendet sind, insbesondere indem zur Datenübertragung höher frequente Stromanteile aufmoduliert sind.

5. System nach mindestens einem der vorangegangenen Ansprüche,
**dadurch gekennzeichnet, dass**
einer der weiteren Steller die Energiezufuhr vom Zwischenkreis an einen zum Steller zugehörigen Verbraucher steuert insbesondere wobei der weitere Steller im Gehäuse des Verbrauchers angeordnet ist oder in einem eigenen Gehäuse.

6. System nach mindestens einem der vorangegangenen Ansprüche,
**dadurch gekennzeichnet, dass**
einer der weiteren Steller den Energieaustausch zwischen Zwischenkreis und einem zum weiteren Steller zugehörigen Energiespeicher (1) steuert, insbesondere wobei der weitere Steller im Gehäuse des Energiespeichers (1) angeordnet ist oder in einem eigenen Gehäuse.

7. System nach mindestens einem der vorangegangenen Ansprüche,
**dadurch gekennzeichnet, dass**
der Zwischenkreis Stromschienen aufweist.

8. System nach mindestens einem der vorangegangenen Ansprüche,
**dadurch gekennzeichnet, dass**
am Zwischenkreis eine Energieerzeugungsquelle (8), insbesondere umfassend Solarzellen, angeschlossen ist.

9. System nach mindestens einem der vorangegangenen Ansprüche, **dadurch gekennzeichnet, dass**
zumindest einer der Verbraucher ein Energiespeicher (1) ist.

10. System nach mindestens einem der vorangegangenen Ansprüche, **dadurch gekennzeichnet, dass**
der Energiespeicher (1) als elektrischer oder chemischer Energiespeicher (1) ausgeführt ist, insbesondere Akkumulator, Ultracap, Batterie oder als sonstiger mechanischer Energiespeicher (1), insbesondere Schwungradspeicher, ausgeführt ist.

## Claims

1. System having an intermediate circuit, in particular a unipolar intermediate circuit, in particular a direct voltage intermediate circuit, comprising an AC/DC converter (5) which is connected to the intermediate circuit, **characterized by** at least one further converter which is embodied as a DC/DC converter (3, 4) and via which energy and/or current can be supplied from the intermediate circuit to at least one load and/or energy storage means (1, 2), a higher-level control unit (7) which is directly connected to at least two converters (3, 4, 5) by means of a data transmission line, in particular in order to specify target values, a power tracker (20) which is connected between an energy generation source (8) and the intermediate circuit, and an MPP control unit which controls the power tracker (20) and receives from the higher-level control unit (7) a specified target value for an MPP control.

2. System according to claim 1, **characterized in that** the converters are arranged in different housings.

3. System according to at least one of the preceding claims, **characterized in that** one or each converter has at least one controllable power semiconductor switch, in particular IGBT, MOSFET or thyristor, in particular wherein the power semiconductor switch is arranged in a half-bridge arrangement of similar power semiconductors.

4. System according to at least one of the preceding claims, **characterized in that** the busbars of the intermediate circuit are used as the data transmission line, in particular by modulating higher-frequency current components for data transmission.

5. System according to at least one of the preceding claims, **characterized in that** one of the further converters controls the supply of energy from the intermediate circuit to a load associated with the converter, in particular wherein the further converter is arranged in the housing of the load or in a separate housing.

6. System according to at least one of the preceding claims, **characterized in that** one of the further converters controls the exchange of energy between the intermediate circuit and an energy storage means (1) associated with the further converter, in particular wherein the further converter is arranged in the housing of the energy storage means (1) or in a separate housing.

7. System according to at least one of the preceding claims, **characterized in that** the intermediate circuit has busbars.

8. System according to at least one of the preceding claims, **characterized in that** an energy generation source (8), in particular comprising solar cells, is connected to the intermediate circuit.

9. System according to at least one of the preceding claims, **characterized in that** at least one of the loads is an energy storage means (1).

10. System according to at least one of the preceding claims, **characterized in that** the energy storage means (1) is embodied as an electrical or chemical energy storage means (1), in particular is embodied as an accumulator, ultracap, battery or as some other mechanical energy storage means (1), in particular as a flywheel storage means.

## Revendications

1. Système comportant un circuit intermédiaire, en particulier un circuit intermédiaire unipolaire, en particulier un circuit intermédiaire à tension continue,
comprenant un convertisseur alternatif-continu (5) qui est relié au circuit intermédiaire, **caractérisé par**
au moins un autre convertisseur qui est conçu comme convertisseur continu-continu (3, 4) au moyen duquel de l'énergie et/ou du courant peuvent être fournis à au moins un consommateur et/ou accumulateur d'énergie (1, 2) à partir du circuit intermédiaire,
une unité de régulation supérieure (7) qui est reliée directement à au moins deux convertisseurs (3, 4, 5) au moyen d'une ligne de transmission de données, en particulier pour la définition de valeurs de consigne,
un suiveur de puissance (20) connecté entre une source de production d'énergie (8) et le circuit intermédiaire,
et une unité de régulation MPP qui commande le suiveur de puissance (20) et reçoit une définition de valeurs de consigne de l'unité de régulation supérieure (7) pour une régulation MPP.

2. Système selon la revendication 1,
**caractérisé en ce**
**que** les convertisseurs sont disposés dans des boîtiers différents.

3. Système selon au moins l'une des revendications précédentes,
**caractérisé en ce**
**qu'**un ou chaque convertisseur présente au moins un commutateur de puissance à semi-conducteurs commandable, en particulier du type IGBT, MOSFET ou thyristor,
en particulier dans lequel le commutateur de puissance à semi-conducteurs est disposé dans une configuration en demi-pont de semi-conducteurs de puissance du même type.

4. Système selon au moins l'une des revendications précédentes,
**caractérisé en ce**
**que** les jeux de barres du circuit intermédiaire sont utilisés comme ligne de transmission de données, en particulier en y modulant des composantes de courant à haute fréquence pour la transmission de données.

5. Système selon au moins l'une des revendications précédentes,
**caractérisé en ce**
**que** l'un des autres convertisseurs commande la fourniture d'énergie par le circuit intermédiaire à un consommateur appartenant au convertisseur, en particulier l'autre convertisseur étant disposé dans le boîtier du consommateur ou dans son propre boîtier.

6. Système selon au moins l'une des revendications précédentes,
**caractérisé en ce**
**que** l'un des autres convertisseurs commande l'échange d'énergie entre le circuit intermédiaire et un accumulateur d'énergie (1) appartenant à l'autre convertisseur, en particulier l'autre convertisseur étant disposé dans le boîtier de l'accumulateur d'énergie (1) ou dans son propre boîtier.

7. Système selon au moins l'une des revendications précédentes,
**caractérisé en ce**
**que** le circuit intermédiaire présente des jeux de barres.

8. Système selon au moins l'une des revendications précédentes,
**caractérisé en ce**
**qu'**une source de production d'énergie (8), comprenant en particulier des cellules solaires, est raccordée au circuit intermédiaire.

9. Système selon au moins l'une des revendications précédentes,
**caractérisé en ce**
**qu'**au moins un des consommateurs est un accumulateur d'énergie (1).

10. Système selon au moins l'une des revendications précédentes,
**caractérisé en ce**
**que** l'accumulateur d'énergie (1) est réalisé sous la forme d'un accumulateur d'énergie électrique ou chimique (1), en particulier d'un accumulateur, d'un ultra-condensateur, d'une batterie ou d'un autre accumulateur d'énergie mécanique (1), en particulier un accumulateur à volant d'inertie.
